**Europäisches Patentamt**

**European Patent Office**

**Office européen des brevets**

(11) Veröffentlichungsnummer: **0 218 893**
**A2**

## (12) EUROPÄISCHE PATENTANMELDUNG

(21) Anmeldenummer: **86112262.0**

(22) Anmeldetag: **04.09.86**

(51) Int.Cl.⁴: **G 01 R 15/07**
**G 01 K 11/20**

(30) Priorität: **11.09.85 CH 3921/85**

(43) Veröffentlichungstag der Anmeldung:
**22.04.87 Patentblatt 87/17**

(84) Benannte Vertragsstaaten:
**CH DE FR LI NL SE**

(71) Anmelder: **BBC Aktiengesellschaft Brown, Boveri & Cie.**
**Haselstrasse**
**CH-5401 Baden(CH)**

(72) Erfinder: **Brändle, Hubert, Dr.**
**Bahnhofstrasse 34**
**CH-8112 Otelfingen(CH)**

(72) Erfinder: **Greuter, Felix, Dr.**
**Im Tobelacher 11**
**CH-5406 Baden-Rütihof(CH)**

(72) Erfinder: **Mosele, Joseph**
**Bromeggstrasse 16**
**CH-4562 Biberist(CH)**

(72) Erfinder: **Perkins, Roger, Dr.**
**Steinstrasse 20A**
**CH-5406 Baden-Rütihof(CH)**

(54) Verfahren und Vorrichtung zur kontaktlosen Fern-Erfassung und -Überwachung des Betriebszustandes eines Hochspannungsgerätes.

(57) Verfahren und Vorrichtung zur kontaktlosen optischen Fern-Erfassung und -Ueberwachung von Temperatur, Strom-, Spannungs- und Frequenzwerten eines Hochspannungsgerätes unter Verwendung von Sensoren (5) und Lichtleitern (6) und/oder Anwendung der Photolumineszenz und/oder Elektrolumineszenz eines Varistorkörpers (1) in Form eines oxydkeramischen Bauelements. Im Falle der Anwendung der Elektrolumineszenz eines mit Co dotierten ZnO-Varistorkörpers (1) kann durch Vergleich zweier Signale die Temperatur und über die Gesamtintensitätsmessung der Strom- und Spannungszustand eines Ueberspannungsableiters dauernd gemessen und überwacht werden. Unter Ausnutzung der Photolumineszenz von dotierter ZnO-Keramik kann auch dessen Temperatur allein überwacht werden.

./...

FIG.1

FIG.7

90/85

11.9.85

Br/dh

- 1 -

## Verfahren und Vorrichtung zur kontaktlosen Fern-Erfassung und -Ueberwachung des Betriebszustandes eines Hochspannungsgerätes

Die Erfindung geht aus von einem Verfahren und einer Vorrichtung zur kontaktlosen Fern-Erfassung und -Ueberwachung des Betriebszustandes eines Hochspannungsgerätes nach der Gattung des Oberbegriffs des Anspruchs 1 und des Anspruchs 14.

Unter Spannung stehende Hochspannungsgeräte müssen aus Sicherheitsgründen periodisch oder laufend kontrolliert werden. Es ist deshalb wünschenswert, ihren Betriebszustand dauernd und womöglich kontaktlos zu überwachen. Dabei steht die Erfassung von Temperatur-, Strom- und Spannungswerten im Vordergrund.

In Hochspannungsanlagen stellt die Erfassung der Strom- und Spannungswerte immer ein mit aufwendigen und kostspieligen Installationen verbundenes Problem dar. Hauptschwierigkeiten bieten dabei u.a. die elektrische Isolation gegenüber erdnahen Messinstrumenten, die benötigte grosse Dynamik sowie der Schutz dieser Messinstrumente im Falle des Auftretens von momentanen oder länger anhaltenden Ueberspannungen resp. -Strömen.

- Bei Schaltvorgängen in Netzen ist die Kenntnis der momentanen Spannungs- oder Stromwerte, der Frequenz und der relativen Phasenlage eine unabdingbare Voraussetzung, was entsprechende Messeinrichtungen voraussetzt.

- Ueberspannungsableiter müssen laufend überwacht und deren Beanspruchung durch einen Ansprechzähler erfasst werden.

- Ein einfacher Spannungsmonitor ist oft wünschbar um beispielsweise festzustellen, ob das Netz unter Spannung steht oder nicht.

Unter den Hochspannungsgeräten nehmen die Ueberspannungsableiter eine sehr wichtige Stellung ein.

Metalloxyd-Ableiter finden heute eine zunehmend breite Anwendung als funkenstreckenfreie Ueberspannungsableiter im Nieder- und Hochspannungsbereich. Aufgrund der eingeschränkten thermischen Stabilität dieser Ableiter ist für den praktischen Einsatz eine dauernde (oder periodische) Ueberwachung des Betriebszustandes erforderlich. Bis heute ist dies nur möglich mittels kostspieliger Strom- und Spannungswandler (Messung der integralen Verlustleistung) oder durch indirekte, ungenaue Methoden (z.B. mA-Meter am Fusspunkt). Im Betrieb sind Metalloxyd-Ableiter aufgrund ihrer Konstruktion und Materialeigenschaften nur in einem beschränkten Temperaturbereich thermisch stabil. Wird dieser Stabilitätsbereich überschritten, so erfolgt ein irreversibler thermischer Durchbruch, der zur Zerstörung des Ableiters führt. Eine direkte Temperaturüberwachung der Metalloxyd-Widerstände ist somit angebracht.

In diesem Zusammenhang ist festzustellen, dass die Technik und Anwendung von Sensoren (hier Optosensoren) schon sehr weit gediehen ist (vergl. C. Ovrén et al., ASEA Zeitschrift 2-84 und ASEA, Badenerstr. 587, Zürich; Luxtron, Fluoroptic Temperature Sensing, Mountain View. CA 94043; York ventures & special optical products, Hampshire SO5 3DQ). Auch ist die Möglichkeit direkter Messung der Photolumineszenz einer Zinkoxyd-Keramik gezeigt worden (Vergl. G.E. Pike, S.R. Kurtz, and P.L. Gourley, H.R. Philipp and Lionel M. Levinson, Electroluminescence in ZnO varistors; Evidence for hole contributions to the breakdown mechanism, J. Appl. Phys. 57, 12, p. 5512, 15 June 1985).

Die Varistoreigenschaften (stark spannungsabhängiger elektrischer Widerstand) von ZnO-Keramiken versehen mit weiteren Metalloxid-Zusätzen sind seit über 10 Jahren bekannt (vergl. M. Matsuoka, Japan. J. Appl. Phys. 10, 736, 1971). ZnO-Varistoren finden heute eine breite Anwendung als funkenstreckenfreie Ueberspannungsableiter sowohl im Niederspannungs- wie im Hochspannungsbereich (vergl. A. Mayer, BBC Mitteilungen 1/2, 48, 1983). Sie zeichnen sich unter anderem aus durch eine hohe elektrische Nichtlinearität ($I \sim U^{\alpha}$ mit $\alpha$ = 20 bis 100 im Durchbruchbereich), ein schnelles und wohl definiertes Ansprech- und "Abschalt"-Verhalten, ein hohes Energieaufnahmevermögen, grosse Lebensdauer und eine nahezu unbeschränkte Dimensionierbarkeit bezüglich Ansprechspannung und maximalem Ableitstrom. Bis heute wurden ausschliesslich diese interessanten elektrischen Eigenschaften der ZnO-Varistoren ausgenutzt. Daneben zeigen aber ZnO-Keramiken noch andere Eigenschaften, wie z.B. Elektrolumineszenz-Effekte, die erst kürzlich erkannt wurden.

Aus dem Vorstehenden ist ersichtlich, dass ein grosses Bedürfnis zur kontaktlosen Erfassung von Temperatur, Spannungszustand und Stromwerten von sich im Betrieb befindlichen Hochspannungsgeräten, insbesondere von Metalloxyd-Ueberspannungsableitern (z.B. ZnO-Varistoren) besteht.

Der Erfindung liegt die Aufgabe zugrunde, ein einfaches und betriebssicheres Verfahren sowie eine geeignete langzeitstabile Vorrichtung zur Erfassung, Auswertung und Ueberwachung, insbesondere Fern-Ueberwachung über grosse Distanzen, der Temperatur, des Spannungs- und Stromzustandes eines Hochspannungsgerätes, vorab eines Metalloxyd-Ueberspannungsableiters, anzugeben, welcher reproduzierbare Ergebnisse liefert und kostengünstig durchgeführt werden kann. Die Temperatur soll an mindestens einem Ort des Geräts unter hohem Potential erfasst werden können, wobei gute Empfindlichkeit und kurze Ansprechzeiten im Temperaturbereich von -50 bis 250°C gefordert werden. Ferner soll das Verfahren unempfindlich gegen elektromagnetische Störungen sein.

Diese Aufgabe wird durch die im kennzeichnenden Teil des Anspruchs 1 und des Anspruchs 14 angegebenen Merkmale gelöst.

Der Grundgedanke für eine passive Temperaturüberwachung besteht in der Verwendung von mindestens einem temperaturabhängigen Optosensor in thermischem Kontakt mit dem Hochspannungsgerät, mindestens einem Lichtleiter sowie einer Mess-, Auswerte- und Meldeeinheit. Temperaturabhängige optische Eigenschaften von Festkörpern, Flüssigkeiten oder Gasen (Absorptionskanten oder -linien, Photo- oder Elektrolumineszenz, Brechungsindex, Ausdehnung etc.) werden in den Sensoren ausgenutzt. Die Wahl des geeigne-

0218893

90/85

ten Sensors hängt u.a. vom Temperaturbereich, der Genauigkeit, der Stabilität etc. ab. Das Messprinzip ist so ausgelegt, dass Alterungseffekte, z.B. im Lichtleiter, keinen Einfluss haben (Messung von Intensitätsverhältnissen, Position spektraler Linien, Zeitkonstanten ...). Der Sensor ist derart an das Hochspannungsgerät angebracht, dass die elektrischen Eigenschaften des Widerstandes nicht gestört werden und trotzdem ein guter Wärmekontakt besteht.

Der Grundgedanke für eine Strom-, Spannungs- und Frequenzüberwachung basiert auf dem bei ZnO-Varistoren beobachteten Phänomen der Elektrolumineszenz. In einem unter Spannung stehenden Varistor werden die zum elektrischen Strom beitragenden Elektronen in dem an den Korngrenzen der Keramik herrschenden elektrischen Feld F beschleunigt. Dadurch gewinnen sie oberhalb einer vorgegebenen Schwellenfeldstärke $F_o$ genügend Energie, um tiefe Störstellen im Varistormaterial durch Stoss zu ionisieren. Die anschliessend stattfindende Rekombination des dadurch erzeugten Loches mit Leitungselektronen kann von der Emission von Photonen begleitet sein, welche extern gemessen werden können. Der Photonenfluss L ist dabei gegeben durch

$$L = Y(U) \cdot I$$

mit: I = Stromstärke und Y(U) = von der Spannung U und der geometrischen Anordnung abhängige Quantenausbeute.

Y(U) kann durch eine Eichmessung bestimmt werden und ist oberhalb der Schwelle $F_o$ nur schwach spannungsabhängig.

Somit kann durch Messung der Lichtintensität L der Strom I und, bei bekannter Strom-Spannungscharakteristik U(I), auch die zugehörige Spannung U bestimmt werden. Die spektrale Verteilung des emittierten Lichtes kann durch die Dotierung der Keramik beeinflusst werden und liegt im Bereiche vom fernen Infrarot bis zu $h\nu = E_g$, wo $E_g$ die Energielücke des Basismaterials der Keramik ist ($E_g = 3.2$ eV für ZnO, $E_g = 3.6$ eV für SiC).

In der praktischen Anwendung wird das Licht über eine energiesammelnde Optik (z.B. Lichtleiter, Spiegel, Linsen etc. ...) auf einen Photodetektor (z.B. Photodiode, Photomultiplier etc.) abgebildet, wobei die Abbildung auch gleichzeitig die elektrische Isolation gewährleisten kann.

In einfacher Ausführung stellt eine solche Anordnung einen Ansprechzähler für Ableiter dar, der zuverlässig, billig, störunanfällig und gefahrlos überlastbar ist und ohne grossen Mehraufwand als Teil eines bestehenden Varistor-Ableiters eingebaut werden kann.

Bei Verwendung von empfindlichen Detektoren kann, bei normalem Betrieb im Prebreakdown-Bereich, der zeitliche Verlauf der Lumineszenz gemessen werden und daraus sowohl die Strom- und Spannungswerte wie auch die Frequenz- und Phasenlage bestimmt werden. Die Nichtlinearität der Keramik begünstigt dabei die genaue Bestimmung der Strommaxima. Um die Mehrdeutigkeit der Phasenlage um $\pm 180°$C zu eliminieren, kann dem betreffenden Varistorelement eine geringe Asymmetrie (z.B. durch eine einmalige starke DC-Belastung) aufgeprägt werden, welche sich auch auf die Lumineszenz überträgt.

Allgemeiner formuliert, bietet die Elektrolumineszenz der Varistoren erstmals die Möglichkeit des Einsatzes von "Leuchtdioden" bei hohen Stromdichten und hohen Feldern. Das Prinzip kann auf alle Keramiken mit Varistoreigenschaften (ZnO, SiC, $TiO_2$, $SrTiO_3$, ZnS, etc.) angewendet werden und lässt sich bezüglich Intensität und spektraler Verteilung über einen weiten Bereich optimieren. Die Absorption der Lumineszenzstrahlung in der Keramik selbst beschränkt den ausnutzbaren Lichtanteil auf eine von der Photonenenergie abhängigen Schicht nahe der Oberfläche der Keramik, was bei der Formgebung und Kontaktierung zu berücksichtigen ist.

Die Erfindung wird anhand der nachfolgenden, durch Figuren näher erläuterten Ausführungsbeispiele beschrieben.

Dabei zeigt:

Fig. 1    einen schematischen Aufriss/Längsschnitt durch ein mit einem Lichtleiter zwecks Temperaturmessung ausgerüstetes Hochspannungsgerät in Form eines Ueberspannungsableiters,

Fig. 2a) ... c)   einen Aufriss/Teilschnitt durch 3 verschiedene Varianten der Befestigung von Lichtleiter und Temperatursensor,

Fig. 3    einen schematischen Aufriss durch eine Anzahl von mit Lichtleitern zwecks Temperaturmessung versehenen Ueberspannungsableitern,

Fig. 4    ein Diagramm der Intensität des zurückgestreuten Lichtes in Funktion des Ortes,

Fig. 5  einen schematischen Aufriss eines mit einer Einrichtung zur Erfassung der Elektrolumineszenz auf der Seite des hohen Potentials ausgerüsteten Hochspannungsgerätes,

Fig. 6  einen schematischen Aufriss eines mit einer Einrichtung zur Erfassung der Elektrolumineszenz auf der Seite des tiefen Potentials ausgerüsteten Hochspannungsgerätes,

Fig. 7  einen Längsschnitt durch eine Einrichtung zur Erfassung der Elektrolumineszenz,

Fig. 8a/8b  einen Aufriss und einen Grundriss einer Sammeloptik mit radialer Lichtankoppelung,

Fig. 9  einen Grundriss einer Sammeloptik mit Lichtankoppelung mittels Glasprismen,

Fig. 10 einen Aufriss und einen Grundriss einer Sammeloptik mit Lichtankoppelung mittels Lichtleiterwicklung.

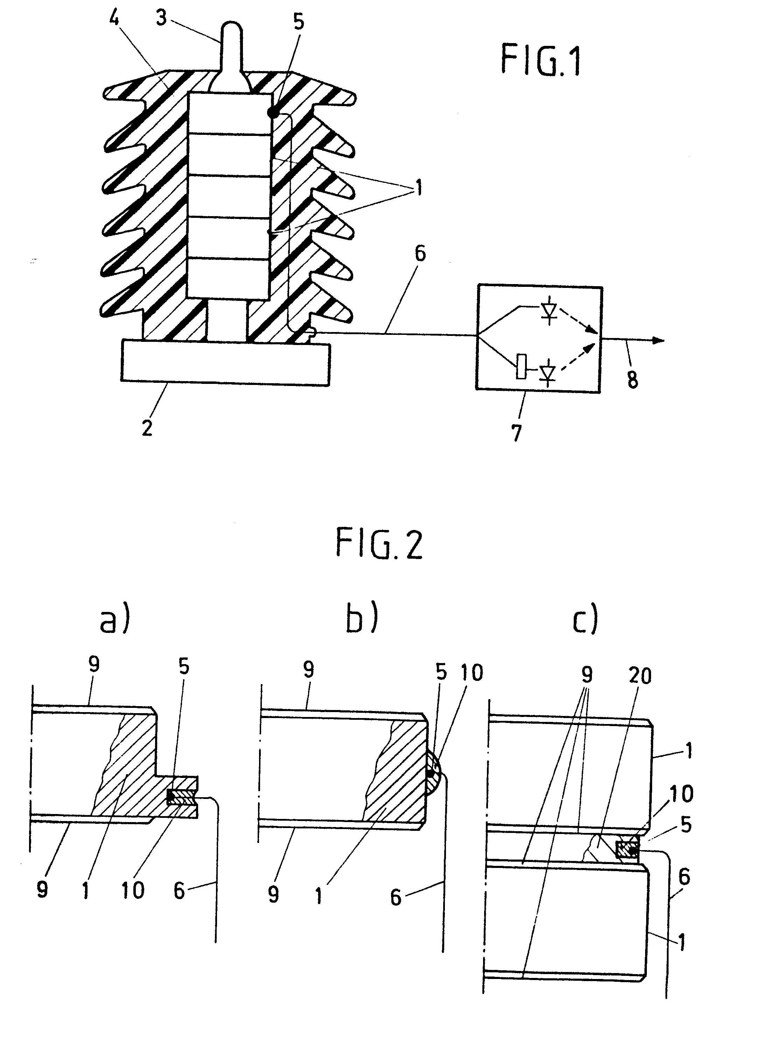

In Fig. 1 ist ein schematischer Aufriss/Längsschnitt durch ein mit einem Lichtleiter zur Temperaturmessung ausgestattetes Hochspannungsgerät in Form eines Ueberspannungsableiters dargestellt. Der aktive Teil des Ueberspannungsableiters besteht aus mehreren stapelartig aufeinandergeschichteten Scheiben, die den Varistorkörper 1 bilden. 2 ist der sich auf Erdpotential befindliche Sockel, 3 die sich auf Hochspannungspotential befindliche Klemme. 4 ist ein meist aus Porzellan oder Kunststoff bestehender Isolierkörper, dessen Ausführungsform für Freiluftaufstellung Schirme aufweist. Ein temperaturempfindlicher Optosensor 5 bewerkstelligt die Verbindung zwischen dem Varistorkörper 1 und einem Lichtleiter 6. Eine aus optischen und elektrischen Bauelementen aufgebaute, einen Sender und Empfänger aufweisende Mess- und Auswertestelle 7 stellt die Verbindung zu einem Meldeorgan 8 (mit Pfeil angedeutet) her.

Die Ausführung ist nicht an den schematischen Aufbau der Fig. 1 gebunden. 4 kann auch das Gehäuse einer gasisolierten Anlage sein.

In Fig. 2a) ... c) ist ein Aufriss/Teilschnitt durch 3 verschiedene Varianten der Lichtleiterbefestigung und der Lichteinkoppelung dargestellt. 9 ist die jeweilige Kontaktfläche einer Scheibe des Varistorkörpers 1. 10 stellt eine Einbettungsmasse für den Optosensor 5 dar. Die übrigen Bezugszeichen entsprechen genau denen der Fig. 1.

Variante 2a) zeigt die Befestigung des Optosensors 5 und des Endes des Lichtleiters 6 in einem Schlitz des mit einem vorspringenden Teil versehenen Varistorkörpers 1.

Variante 2b) zeigt eine Befestigung und Lichtankoppelung mittels direkt auf den Mantel des Varistorkörpers 1 aufgebrachter Einbettungsmasse 10.

Variante 2c) zeigt eine Befestigung des Optosensors 5 in einer Ausnehmung der Metallscheibe 20 zwischen den Kontaktflächen 9 von benachbarten Scheiben des Varistorkörpers 1.

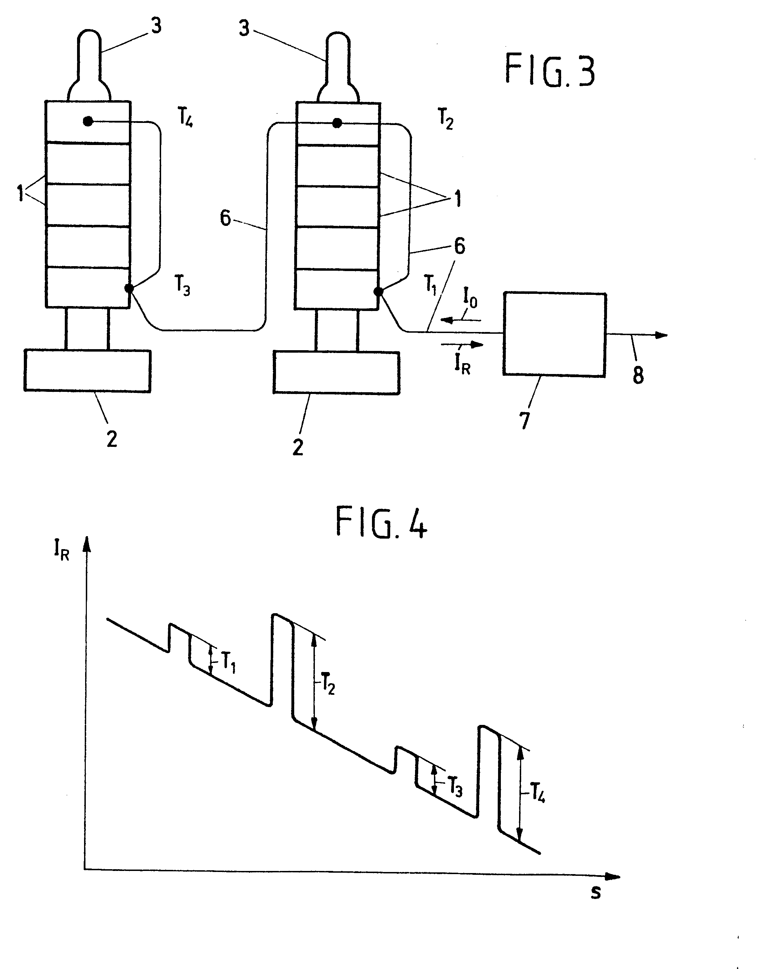

In Fig. 3 ist ein schematischer Aufriss durch eine Anzahl von mit Lichtleitern zwecks Temperaturmessung ver-

0218893

sehenen Ueberspannungsableitern dargestellt. Es können hier gleichzeitig mehrere Temperaturen $T_1$ ... $T_n$ (im vorliegenden Fall $T_1$, $T_2$, $T_3$ und $T_4$) erfasst werden. Die Mess- und Auswertestelle 7 sendet Licht (angedeutet durch Pfeil $I_o$) über den Lichtleiter 6 bis zu den zu messenden Punkten, wo es teilweise zurückgestreut wird (angedeutet durch den Pfeil $I_R$). Selbstverständlich können Temperaturen $T_1$ ... $T_n$ an beliebigen Punkten, über längere Teilstrecken (z.B. durch Umwickeln) und an einer Vielzahl von Hochspannungsgeräten gleichzeitig gemessen werden. Alle Bezugszeichen entsprechen denjenigen der vorangegangenen Figuren.

Fig. 4 zeigt ein Diagramm der Intensität des zurückgestreuten Lichtes in Funktion des Ortes für das Verfahren gemäss Darstellung der Fig. 3. S ist die Orts-(Weg-) Koordinate längs des Lichtleiters 6, stellt also die Distanz der zu überwachenden Temperaturpunkte $T_1$ ... $T_4$ vom apparateseitigen Ende des Lichtleiters 6 (Ort der Mess- und Auswertstelle 7) dar. $I_R$ ist die Intensität des zurückgestreuten Lichts. Die den Temperaturen $T_1$ ... $T_4$ entsprechenden $\triangle I_R$-Werte sind durch mit Pfeilspitzen versehenen Masslinien angedeutet.

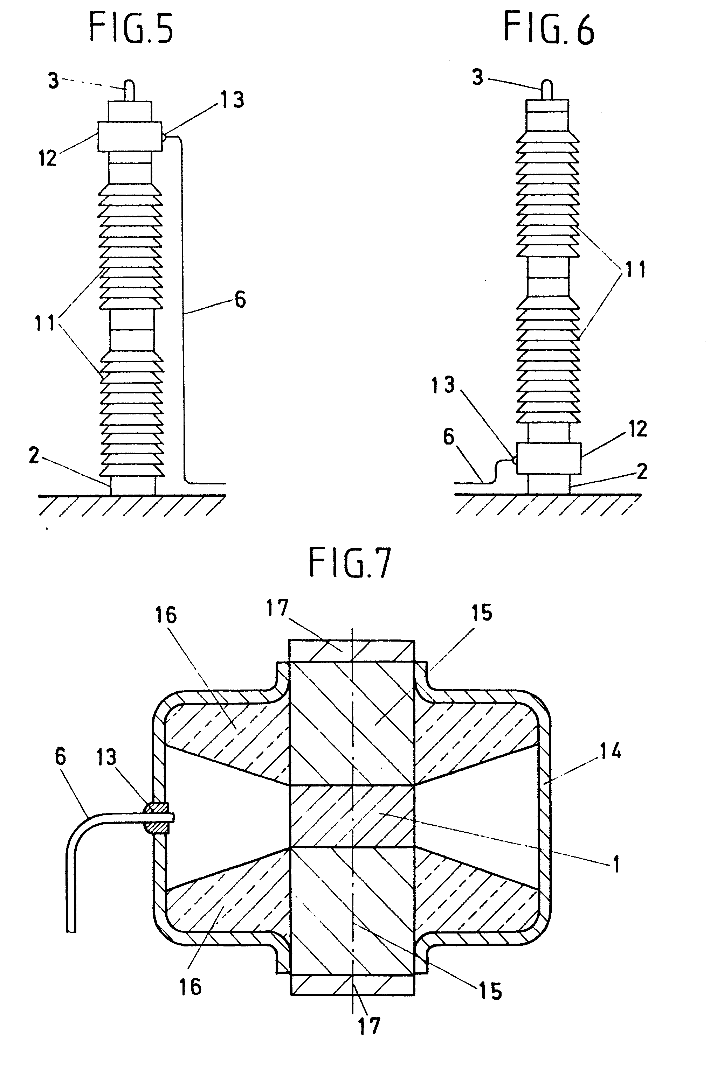

Fig. 5 stellt einen schematischen Aufriss eines mit einer Einrichtung zur Erfassung der Elektrolumineszenz auf der Seite des hohen Potentials ausgerüsteten Hochspannungsgerätes dar. Der an Erdpotential liegende Sockel 2 trägt das Hochspannungsgerät 11, im vorliegenden Fall einen Ueberspannungsableiter. Auf dessen an hohem Potential liegender Seite befindet sich die zur Erfassung der Elektrolumineszenz dienende Einrichtung 12, welche als stets in gleicher Weise wiederkehrende Baueinheit ausgeführt ist und eine Durchführung 13 für einen Lichtleiter 6 besitzt. 3 ist die sich auf Hochspannungspotential befindliche obere Klemme.

Fig. 6 stellt einen schematischen Aufriss eines mit einer
Einrichtung zur Erfassung der Elektrolumineszenz auf
der Seite des tiefen Potentials (im vorliegenden Fall
Erdpotential) ausgerüsteten Hochspannungsgerätes dar.
Die Bezugszeichen entsprechen denjenigen der Fig. 5.

Fig. 7 zeigt einen Längsschnitt durch eine Einrichtung
zur Erfassung der Elektrolumineszenz gemäss Bezugszeichen
12 der Fig. 5 oder Fig. 6. Der Querschnitt dieser als
Baueinheit ausgeführten Einrichtung kann kreisförmig
oder polygonal sein, d.h. der Körper kann aus rotationssymmetrischen Einzelteilen oder aus solchen mit gleichseitigen Vielecken als Grundflächen bestehen. In einem
Isoliergehäuse 14 ist auf jeder Stirnseite je ein Metallblock 15 befestigt, welcher zusätzlich in je einen Körper
aus Einbettungsmasse 16 zur Wärmeableitung eingebettet
ist. Auf jeder aussenliegenden Stirnseite der Kupferblöcke 15 befindet sich eine Kontaktplatte 17, welche
den elektrischen und mechanischen Anschluss an das benachbarte Bauteil des Hochspannungsgeräts gewährleistet.
Das Isoliergehäuse 14 ist mit einer Durchführung 13 zur
Aufnahme eines die Elektrolumineszenz des Varistorkörpers 1 erfassenden Lichtleiters 6 versehen.

In Fig. 8a)/8b) ist ein Aufriss und ein Grundriss einer
Sammeloptik mit radialer Lichtankoppelung dargestellt.
Die Enden einzelner Fasern des Lichtleiters 6 stehen
radial zu dem zylindrischen Mantel des Varistorkörpers 1.

In Fig. 9 ist ein Grundriss einer Sammeloptik mit Lichtankoppelung mittels Glasprismen dargestellt. Die Glasprismen 18 sind je auf ihrer Basisfläche halbzylindrisch ausgenommen, und umschliessen den Varistorkörper 1 konzentrisch. Jedes Prisma 18 ist mit ortsabhängigem Brechungsindex ausgeführt, dergestalt, dass das gesamte anfallende Licht gegen den Anschluss des Lichtleiters 6 hin konzentriert wird.

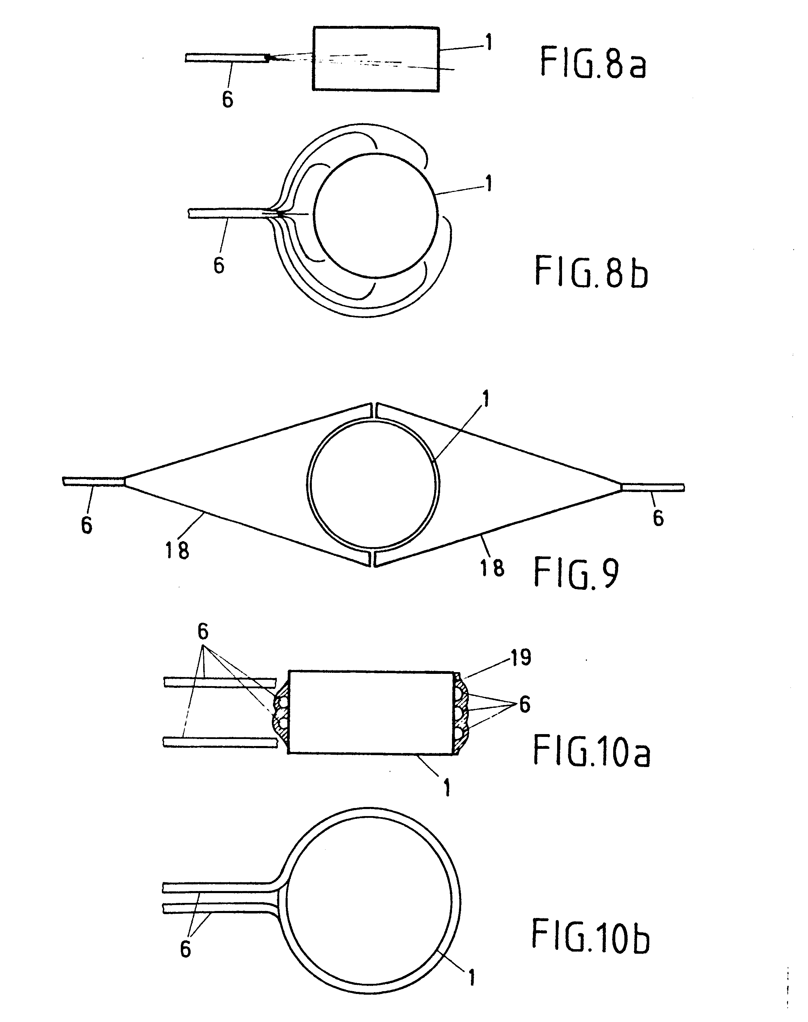

Fig. 10 stellt einen Aufriss und einen Grundriss einer Sammeloptik mit Lichtankoppelung mittels einer Lichtleiterwicklung dar. Die einzelnen Fasern des Lichtleiters 6 sind auf der auf dem Varistorkörper 1 aufliegenden Seite abgeflacht und in Form eines Wendels um letzteren herumgewickelt. Zur Befestigung ist ein aus einem Kunststoffkleber bestehender Ueberzug (Einbettungsmasse) 19 vorgesehen. Der Durchmesser der Fasern des Lichtleiters 6 ist in dieser Figur stark übertrieben dargestellt.

Ausführungsbeispiel 1:

Siehe Fig. 1, 2a!
Temperaturmessung.
Als Hochspannungsgerät, dessen Temperatur überwacht wurde, stand ein Ueberspannungsableiter bestehend aus zwei parallelgeschalteten Säulen zur Verfügung. Der Isolierkörper 4 hatte einen Durchmesser von 350 mm, die Höhe des Isolierkörpers 4 und des Sockels 2 zusammen betrug 1700 mm. Der aktive Teil bestand aus einem Stapel von Varistorkörpern 1 (dotiertes ZnO), welche teilweise in eine Silikonmasse eingebettet waren (nicht gezeichnet). Der Lichtleiter 6 bestand aus einer optischen Faser (Handelsbezeichnung Fibropsil QSF 200 A) mit einem Kerndurchmesser von 200 $\mu$m und einer Länge von 50 m. Auf dem Umfang der obersten Scheibe des Varistorkörpers 1 war ein auf Photolumineszenz ansprechender Optosensor 5 aus polykristallinem, mit 1 Gew.-% Co dotiertem ZnO in gutem thermischen Kontakt mit dem Varistorkörper 1 angebracht. Der Lichtleiter 6 war gemäss Fig. 2a in einer Aussparung des Varistorkörpers 1 mittels Silikonharz als Einbettungsmasse 10 fixiert und an den Optosensor 5 angeschlossen. Eine Modifikation zu dieser Anordnung bestand darin, dass direkt die Co-dotierte ZnO-Keramik des Varistorkörpers 1 als Optosensor 5 verwendet wurde. Die Mess- und Auswertestelle 7 war mit einem Laser (He/Ne-Laser von ca. 0,2 mW Leistung), zwei optischen Filtern und einer Photodiode ausgerüstet. Die Photolumineszenz wurde mittels Laser angeregt. Die Detektion erfolgte mit einer Silizium-PIN-Photodiode, die spektrale Trennung mittels zweier Langpassfilter. Von letzteren war das eine für das temperaturabhängige Photolumineszenzsignal im Wellenlängenbereich von 680 - 720 nm voll durchlässig (Absorptionskante bei ca. 670 nm), während das andere nur teilweise durchlässig war (Absorptionskante bei ca. 720 nm). Das Verhältnis der beiden Intensitäten wurde über einen Quotientenbildner elektronisch ermittelt und ist nur von der Temperatur abhängig. Ueber eine Eichkurve wurde die Scheibentemperatur des Varistorkörpers 1 im Bereich von -60°C bis +200°C nachgeprüft.

Die Mess- und Auswertestelle 7 kann statt mit einem Laser mit einer GaAsP-Leuchtdiode und statt mit einer oder zwei Photodioden mit einem oder zwei Photomultipliern ausgerüstet sein und ein faseroptisches Verzweigungsstück enthalten.

Ausführungsbeispiel_2:

Temperaturmessung.
Eine Temperaturmessung wurde ähnlich der in Beispiel 1 genannten Methode durchgeführt. An der Mess- und Auswertestelle 7 wurde die spektrale Trennung jedoch wie folgt durchgeführt. Das Photolumineszenzsignal wurde durch ein um ca. 5° gegenüber der auf dem Strahl senkrechten Ebene gekipptes Interferenz-Bandpassfilter (zentrale Wellenlänge ca. 710 nm, Bandbreite ca. 20 nm) auf einen ersten Detektor (Photodiode) geleitet, welcher ein erstes elektrisches Signal erzeugte. Der am Filter reflektierte Lichtanteil wurde auf einem zweiten Detektor (Photodiode) geleitet, welcher ein zweites elektrisches Signal erzeugte. Ueber eine Eichkurve ergab sich aus dem Verhältnis der beiden elektrischen Signale die gesuchte Temperatur.

Ausführungsbeispiel 3:

Siehe Fig. 5, 7!
Strom- und Spannungsmessung mittels Elektrolumineszenz.

Als Hochspannungsgerät, dessen Strom- bzw. -Spannung zu überwachen war, wurde ein Ueberspannungsableiter 11 ähnlich schematischer Fig. 5 verwendet. Die totale Höhe betrug ca. 2950 mm, der Aussendurchmesser ca. 350 mm. Der aktive Teil bestand aus einem Stapel von aufeinandergeschichteten ZnO-Varistor-Scheiben. Die Einrichtung 12 zur Erfassung der Elektrolumineszenz gemäss schematischer Darstellung in Fig. 7 bestand aus einem Varistorkörper 1 (dotiertes ZnO) von 80 mm Durchmesser und 30 mm Höhe. Die Kupferblöcke 15 hatten zylindrische Form und besassen den gleichen Durchmesser wie der Varistorkörper 1. Die zur Verbesserung der Wärmeableitung und Fixierung dienende Einbettungsmasse 16 bestand aus Silikon. Die als Montageflansche gegenüber Fig. 7 abweichend ausgebildeten Kontaktplatten 17 bestanden aus Aluminium. Das Ganze befand sich in einem Isoliergehäuse 14 aus Porzellan, welches in Abweichung von Fig. 7 an der oberen Stirnseite mit einem vorkragenden Schirm versehen war. Als lichtsammelnde Optik wurde ein einzelner Lichtleiter 6 (Typ Fibropsil QSF 1000 A) mit einem Kerndurchmesser von 1000 $\mu$m verwendet, welcher innerhalb des Isoliergehäuses 14 (in Abweichung von Fig. 7) auf einer vorgeformten Halterung aus Plexiglas fixiert war, derart, dass das Ende des Lichtleiters 6 in radialer Stellung auf halbe Höhe des Varistorkörpers 1 in einem Abstand von 30 mm von dessen Mantelfläche zu liegen kam. Der Lichtleiter wurde (in Abweichung von den Figuren 5 und 7) im Innern des Ableiters 11 auf Erde geführt. Die Gesamtlänge des Lichtleiters 6 betrug ca. 100 m.

Die Mess- und Auswertestelle hatte die Aufgabe, einerseits die Gesamtintensität der gesammelten Elektrolumineszenz zu messen, welche proportional zum durch den Varistorkörper 1 fliessenden Strom ist, andererseits die spektrale Lage des Lumineszenzüberganges bei einer Wellenlänge von ca. 700 nm zu ermitteln, aus welcher sich die Temperatur des Varistorkörpers auf Grund einer Eichkurve ableiten liess. Daraus liess sich dann der bezüglich der Temperaturvariation korrigierte Proportionalitätsfaktor bestimmen, welcher für die Gesamtintensität der Elektrolumineszenz und damit der Stromstärke, bzw. der am Varistorkörper 1 liegenden Spannung massgebend war.

Nach einer ersten Methode wurde das ankommende Licht über ein faseroptisches Kopplungsstück (Verzweigung) auf 2 Fasern aufgeteilt. Eine dieser beiden aus Lichtleitern bestehenden Kanäle war direkt mit einem Photodetektor verbunden, welcher der Messung der Gesamtintensität des Lichtes diente (erstes Signal proportional der Gesamtintensität). Der zweite Kanal wurde über ein Bandkantenfilter (Absorptionskante bei einer Wellenlänge von ca. 720 nm) ebenfalls mit einem Photodetektor verbunden, welcher ein zweites Signal liefert. Aus dem Verhältnis der Signale konnte über eine Eichkurve die Temperatur des Varistorkörpers 1 bestimmt werden, während sich aus dem ersten Signal - unter Berücksichtigung der entsprechenden Temperaturkorrektur - direkt die Stromstärke I bzw. die Spannung U ergab.

Ausführungsbeispiel 4:

Siehe auch Fig. 8a und 8b!

Strom- und Spannungsmessung.

Aehnlich Beispiel 3 wurde eine Strom- bzw. Spannungsmessung vorgenommen. Dabei wurde jedoch als lichtsammelnde Optik eine Anordnung ähnlich Fig. 8a und 8b verwendet:

3 radiale, senkrecht auf den Mantel des Varistorkörpers
1 gerichtete Lichtleiterbündel (Glasfaserleiter für Beleuchtungszwecke, Fa. Volpi AG, Urdorf, CH) in je 120°
Versetzung. Jedes Bündel hatte einen Durchmesser von
3,5 mm und war je in einer Plexiglashalterung fixiert.
Noch innerhalb der Einrichtung 12 waren die 3 Bündel
zu einem einzigen von ca. 6 mm Durchmesser zusammengefasst, welches durch die untere Kontaktplatte (Montageflansch) 17 durchgeführt war. Dieses Bündel hatte eine
Länge von ca. 10 m.

An der Mess- und Auswertestelle wurde das ankommende
Licht durch ein um ca. 10° gegenüber der auf dem Strahl
senkrechten Ebene gekipptes Interferenz-Bandpassfilter
(zentrale Wellenlänge ca. 710 nm) auf einen ersten Photodetektor geleitet (erstes Signal). Das am Interferenzfilter reflektierte Licht wurde auf einen zweiten Photodetektor gegeben (zweites Signal). Aus dem Verhältnis
der Signale wurde, wie oben angegeben, die Temperatur
des Varistorkörpers 1 bestimmt, während die Summe der
beiden Signale die Gesamtintensität und damit den der
Stromstärke bzw. Spannung proportionalen Wert lieferte.

Statt ein längeres Leiterbündel (6 mm Durchmesser) zur
Lichtleitung zu verwenden, kann das Licht bereits innerhalb der Einrichtung 12 über eine Linse mit kurzer Brennweite und eine Gradientenindexlinse auf einen einzelnen
Lichtleiter mit ca. 1000 µm Kerndurchmesser geleitet
werden. Letzerer kann eine Länge von mehreren Hundert
Metern besitzen, wobei auf diese Weise eine kostengünstige Fernleitung verwirklicht werden kann, ohne grosse
Abbildungsverluste in Kauf nehmen zu müssen.

Bei allen hier beschriebenen Verfahren und Vorrichtungen
wurde die Lumineszenz ausgenutzt, die bei ZnO-Varistoren
durch Co-Dotierung induziert wird.

Als Photodetektoren wurden sowohl Silizium-PIN-Photodioden (UDT-122A/2500) wie Photomultiplier (RCA 4832)
verwendet. Mit letzteren konnte die Ansprechempfindlichkeit für die Stromstärke I bis in den µA-Bereich hinunter gesteigert werden, während bei der Verwendung von
Photodioden diese Grenze im mA-Bereich lag.

Für alle Ausführungsbeispiele wurden entsprechende Eichmessungen durchgeführt.

Im Falle einer Grob-Ueberwachung (z.B. als Ansprechzähler) kann auf eine zusätzliche Temperaturbestimmung verzichtet und lediglich die Gesamtindensität gemessen werden (keine Bestimmung der spektralen Lage notwendig).

Die Erfindung ist nicht durch die Ausführungsbeispiele
begrenzt.

Zur Temperaturmessung mittels Photolumineszenz kann das
Hochspannungsgerät mit einem oxydkeramischen Bauteil
ausgerüstet sein oder an geeigneter Stelle eine spezielle, aufgebrachte Lumineszenzschicht aufweisen. Zur

Temperaturmessung und -Registrierung kann aber auch die Elektrolumineszenz eines oxydkeramischen Bauteils bzw. eines elektrisch belasteten Ueberspannungsableiters als Hochspannungsgerät direkt herangezogen werden.

Ausser Strom- und Spannungswerten kann nach der beschriebenen Elektrolumineszenz-Methode auch die Frequenz einer an den Ueberspannungsableiter angelegten Spannung bestimmt werden. Mehrere Spannungs- und Stromwerte örtlich getrennter Geräte können mittels Elektrolumineszenz individuell ermittelt, lichtoptisch weitergeleitet und an einer einzigen Stelle zentral ausgewertet werden (vergl. auch Fig. 5 für Temperaturmessung). Mittels Elektrolumineszenz kann die Anzahl der Ansprechungen sowie die Höhe und/oder Dauer von Ueberspannung und Ansprechstrom eines Ueberspannungsableiters gemessen, registriert und gespeichert werden. Ferner ist die separate Erfassung und Abbildung der positiven und negativen Halbwelle des Stromes resp. die Phasenlage eines mit Wechselspannung betriebenen Hochspannungsgerätes mittels Elektrolumineszenz möglich. Dazu werden elektronische Mittel ähnlich wie oben beschrieben eingesetzt.

Als Varistorkörper mit Lumineszenzeigenschaften können keramische Bauteile aus einem stark spannungsabhängigen Widerstand auf der Basis von $ZnO$, $SiC$, $TiO_2$, $ZnS$ oder $SrTiO_3$ Verwendung finden. Im Falle eines ZnO-Varistors wird die Elektrolumineszenz vorzugsweise durch eine Dotierung mit Co, Mn oder einer seltenen Erde erzielt.

Das Verfahren kann derart gestaltet werden, dass die durch Elektrolumineszenz emittierten Photonen entweder auf der Seite des höchsten elektrischen Potentials des Hochspannungsgerätes aufgefangen und mittels einem oder mehreren Lichtleitern einer Mess- und Auswertestelle auf Erdpotential zugeleitet werden, oder dass sie auf der Seite des tiefen Potentials aufgefangen und ebenfalls mittels Lichtleiter oder mit konventionellen lichtoptischen Methoden und Mitteln der Mess- und Auswertestelle auf Erdpotential zugeführt werden.

Für die Einrichtung 12 (Fig. 5) kann vorzugsweise als Einbettungsmasse 16 entweder Silikon oder Kautschuk verwendet werden. Dabei kann die Form vorteilhafterweise Kegelform sein, was seinerseits einen bevorzugten doppelkegelförmigen Profilraum zur Aufnahme der Sammeloptik bedingt. An mindestens einer Stelle der Einrichtung 12 (auf der Mantel- oder Stirnseite) ist eine Oeffnung mit einer Durchführung 13 zur Aufnahme mindestens eines Lichtleiters 6 vorhanden. Die Sammeloptik ähnlich Fig. 9 kann auch aus nur einem verspiegelten Glasprisma 18 und nur einem abgehenden Lichtleiter 6 bestehen.

Patentansprüche

1. Verfahren zur kontaktlosen Fern-Erfassung und -Ueberwachung des Betriebszustandes, insbesondere von Temperatur-, Spannungs- und Stromwerten eines Hochspannungsgerätes, dadurch gekennzeichnet, dass die zu messende physikalische Grösse durch einen Sensor (5; 12) über energiesammelnde Mittel lichtoptisch erfasst, in mindestens einem Lichtleiter (6) transportiert und an eine Mess- und Auswertestelle (7) geleitet wird, und dass aus der gemessenen Lichtintensität mit Hilfe einer bekannten Charakteristik der Betriebszustand bestimmt wird.

2. Verfahren nach Anspruch 1, dadurch gekennzeichnet, dass die Temperatur mit mindestens einem temperaturempfindlichen Optosensor (5) erfasst und das entsprechende optische Signal in mindestens einem Lichtleiter (6) zu einer Mess- und Auswertestelle (7) und einem Meldeorgan (8) geleitet wird, welche aus einem Sender- und Empfängerteil und einer Auswerte- und Meldelogik bestehen.

3. Verfahren nach Anspruch 2, dadurch gekennzeichnet, dass zur Temperaturmessung die Photolumineszenz eines oxydkeramischen Bauteils oder einer auf das Hochspannungsgerät aufgebrachten Lumineszenzschicht herangezogen wird.

4. Verfahren nach Anspruch 1, dadurch gekennzeichnet, dass mittels Elektrolumineszenz die Temperatur eines elektrisch belasteten Ueberspannungsableiters gemessen und registriert wird.

5. Verfahren nach Anspruch 1, dadurch gekennzeichnet, dass Spannungs-, Strom- und/oder Frequenzwerte unter Verwendung eines Varistorkörpers (1) in Form eines Ueberspannungsableiters erfasst werden, indem der Varistorkörper (1) als oxydkeramisches Bauteil durch Dotierung mit einem oder mehreren Elementen unter dem Einfluss einer angelegten elektrischen Spannung zur Elektrolumineszenz angeregt wird, wobei die dadurch emittierten Photonen über energiesammelnde Mittel an die Mess- und Auswertestelle (7) geleitet werden und dass daraus der Betriebsstrom und mit Hilfe einer bekannten, nicht-linearen Strom-Spannungscharakteristik des Varistorkörpers (1) die Betriebsspannung bestimmt werden.

6. Verfahren nach Anspruch 5, dadurch gekennzeichnet, dass die Spannungs- und Stromwerte mehrerer örtlich getrennter Ueberspannungsableiter mittels Elektrolumineszenz individuell ermittelt, die jeweiligen Ergebnisse lichtoptisch weitergeleitet und an einer einzigen Stelle zentral ausgewertet werden.

7. Verfahren nach Anspruch 5, dadurch gekennzeichnet, dass mittels Elektrolumineszenz die Anzahl der Ansprechungen sowie die Höhe und/oder Dauer der Ueberspannung und des Ansprechstromes eines Ueberspannungsableiters gemessen, registriert und gespeichert wird.

8. Verfahren nach Anspruch 5, dadurch gekennzeichnet, dass mittels Elektrolumineszenz die positive und die negative Halbwelle des Stromes eines mit Wechselspannung betriebenen Hochspannungsgerätes separat erfasst und mit elektronischen Mitteln abgebildet wird.

9. Verfahren nach Anspruch 5, dadurch gekennzeichnet, dass mittels Elektrolumineszenz die Frequenz des Stromes eines mit Wechselspannung betriebenen Hochspannungsgerätes erfasst und mit elektronischen Mitteln abgebildet, registriert oder gespeichert wird.

10. Verfahren nach Anspruch 5, dadurch gekennzeichnet, dass als Varistorkörper (1) ein keramisches Bauteil aus einem stark spannungsabhängigen Widerstand auf der Basis von ZnO, SiC, $TiO_2$, ZnS oder $SrTiO_3$ verwendet wird.

11. Verfahren nach Anspruch 10, dadurch gekennzeichnet, dass als Varistorkörper (1) ein keramisches Bauteil aus einem stark spannungsabhängigen Widerstand auf ZnO-Basis verwendet wird, wobei die Elektrolumineszenz durch eine Dotierung mit Kobalt, Mangan oder einer seltenen Erde erzielt wird.

12. Verfahren nach Anspruch 5, dadurch gekennzeichnet, dass die durch Elektrolumineszenz emittierten Photonen auf der Seite des höchsten elektrischen Potentials des Hochspannungsgerätes aufgefangen und mittels einem oder mehreren Lichtleitern (6) einer Mess- und Auswertestelle auf Erdpotential zugeführt werden.

13. Verfahren nach Anspruch 5, dadurch gekennzeichnet, dass die durch Elektrolumineszenz emittierten Photonen auf der Seite des tiefsten elektrischen Potentials des Hochspannungsgerätes aufgefangen und mittels konventioneller lichtoptischer Methoden oder mittels Lichtleiter (6) einer Mess- und Auswertestelle auf Erdpotential zugeführt werden.

14. Vorrichtung zur kontaktlosen Fern-Erfassung und -Ueberwachung des Betriebszustandes eines Hochspannungsgerätes unter Verwendung eines Varistorkörpers (1) in Form eines Ueberspannungsableiters, dadurch gekennzeichnet, dass als Varistorkörper (1) ein aus dotiertem ZnO bestehendes zylindrisches oder prismatisches oxydkeramisches Bauelement vorgesehen ist, welches zwischen zwei Metallblöcken (15) gehalten ist, die ihrerseits in den Stirnseiten eines zentralsymmetrischen hohlzylinderartigen Isoliergehäuses (14) zwischen Kontaktplatten (17) gefasst und in kegelförmige Einbettungsmassen (16) aus Silikon oder Kautschuk als Stützkörper eingebettet sind und dass der zwischen dem Isoliergehäuse (14) und der Einbettungsmasse (16) verbleibende, doppelkegelförmige Hohlraum zur Aufnahme einer Sammeloptik vorgesehen ist, und dass ferner an mindestens einer Stelle eine Oeffnung mit einer Durchführung (13) zur Aufnahme mindestens eines Lichtleiters (6) vorhanden ist.

15. Vorrichtung nach Anspruch 14, dadurch gekennzeichnet, dass die Sammeloptik aus einer Reihe zunächst radial verlaufender und dann zu einem einseitigen Bündel zusammengefasster Lichtleiter (6) besteht.

16. Vorrichtung nach Anspruch 14, dadurch gekennzeichnet, dass die Sammeloptik aus mindestens einem an einer Seitenfläche mit runder zylindrischer Ausnehmung versehenen verspiegelten Glasprisma (18) mit ortsabhängigem Brechungsindex und aus mindestens einem abgehenden Lichtleiter (6) besteht.

17. Vorrichtung nach Anspruch 14, dadurch gekennzeichnet, dass die Sammeloptik aus einer wendelförmigen
Wicklung eines an ihrem inneren Umfang angeschliffenen, mit einem Kunststoffkleber als Ueberzug (19)
befestigten Lichtleiters (6) besteht, welcher den
als Zylinder ausgebildeten Varistorkörper (1) koaxial
umschlingt.

FIG.1

FIG.2

a)　　　　b)　　　　c)

FIG.3

FIG.4

FIG.5

FIG.6

FIG.7

FIG.8a

FIG.8b

FIG.9

FIG.10a

FIG.10b